# EUROPEAN PATENT SPECIFICATION

(11) **EP 3 848 662 B1**
(45) Date of publication and mention of the grant of the patent: **16.11.2022**
(21) Application number: 20217804.2
(22) Date of filing: 30.12.2020
(51) Int. Cl.: F28D 15/02, F28D 21/00, F28F 3/06, F28F 3/14, H01L 23/367, H01L 23/427

(54) **HEAT EXCHANGER FIN AND MANUFACTURING MEHTOD OF THE SAME**
WÄRMETAUSCHRIPPE UND HERSTELLUNGSVERFAHREN DAFÜR
AILETTE D'ÉCHANGEUR DE CHALEUR ET SON PROCÉDÉ DE FABRICATION

(30) Priority: 13.01.2020 TW 109101118; 06.02.2020 US 202062970731 P
(43) Date of publication of application: 14.07.2021
(73) Proprietor: Cooler Master Co., Ltd., Taipei City 114065 (TW)
(72) Inventor: Lin, Chia-yu, 23586 New Taipei City (TW); Cheng, Shan-yin, 23586 New Taipei City (TW)
(74) Representative: Grünecker Patent- und Rechtsanwälte PartG mbB

(56) References cited:
- EP-A1- 2 677 261
- EP-A1- 3 550 947
- CN-A- 109 341 401
- DE-U1- 20 216 065
- US-A1- 2018 308 780

## Description

### TECHNICAL FIELD

The present invention relates to a heat exchanger fin according to the preamble of claim 1. Such a fin is known from EP 3 550 947 A1. It further relates to a heat exchanger that includes such a fin as well as to manufacturing methods of such a fin.

### BACKGROUND

During operation of electric and electronic elements, devices and systems, the heat generated thereby must be dissipated quickly and efficiently to keep operating temperature within manufacturer recommended ranges, under, at times, challenging operating conditions. As these elements, devices and systems increase in functionality and applicability, so does the power requirements thereof, this in turn increases cooling requirements.

Several techniques have been developed for extracting heat from electric and electronic elements, devices and systems. One such technique is an air-cooling system, wherein a heat exchanger is in thermal contact with the elements, devices or systems, transporting heat away therefrom, and then air flowing over the heat exchanger removes heat from the heat exchanger. One type of heat exchanger consists of a plurality of fins extending from a base plate. The plurality of fins increases the rate of convective heat transfer to or from an environment of the heat exchanger, by increasing the surface area of a heat source in thermal contact with the heat exchanger. Heat is transferred from the heat source to the base plate, the base plate to the plurality of fins and the environment, and the plurality of fins to the environment.

Convective heat transfer may be aided by a fan, blower, or any other source, or natural convection may be employed. For natural convection, higher temperature air is less dense than its surrounding air and rises out of the heat exchanger and plurality of fins naturally, opposite the direction of gravity. For natural convection, the attached positioning of the heat exchanger and orientation of the plurality of fins during operation is in a direction that will not block air movement. During operation, when positioned horizontally, the plurality of fins face upward, and when positioned vertically, the plurality of fins is oriented to allow higher temperature air to conveniently rise.

The thermal performance of the plurality of fins of the heat exchangers is dependent on heat transfer effectiveness. Thus, shape, thickness, material, and enhancements all contribute to the thermal performance of the plurality of fins. One type of enhancement is a closed-looped system, whereby a vacuum area also carries heat from the heat source by evaporation of a working fluid which is spread by a vapor flow filling the vacuum. The vapor flow eventually condenses over cooler surfaces, and, as a result, the heat is distributed from a heat source evaporation interface surface to a larger condensation cooling surface area. Flow instabilities occur inside of the enhanced heat exchangers due to the heat input at the heat source end and heat output at the cooling surface end. Thereafter, condensed fluid flows back to near the evaporation surface.

When a closed-looped heat exchanger is positioned vertically, the plurality of fins is aligned such that higher temperature air can rise; however, the added weight of the closed-looped enhancement requires more costly attachment materials or non-standard attachment mechanisms. Also, due to the vertical alignment, heat transfer efficiency of the closed-looped enhancement decreases at a greater and greater rate along the mounted surface of the heat exchanger the further the mounted surface is away from ground due to the inefficiency of the working fluid to rise against the direction of gravity. Thus, dry-out is increased from occurring, causing the electric and/or electronic elements, devices and/or systems to overheat, fail or be damaged. Meanwhile, for electric and/or electronic elements, devices and systems that operate vertically, there are often more than one heat source areas which will need cooling by the heat exchanger. In general, maximum operating temperature allowance for lower-powered electric and/or electronic elements and/or devices are less than that of higher-powered electric and/or electronic elements and/or devices. Thus, lower-powered electric and/or electronic elements and/or devices are positioned closer to ground versus higher powered electric and/or electronic elements and/or devices due to rising of higher temperature air. Nonetheless, for enhanced heat exchangers, the largest heat dissipation efficiency is often found closer to ground, where a majority of the working fluid agglomerates due to gravity.

CN 109 341 401 A discloses a cooling fin and a radiator having a plurality of such cooling fins. The cooling fin is preferably composed from two substrates to form a plate structure and sealed hollow cavity is disposed between the two substrates. The hollow cavity is filled with a phase-change working medium and is under a negative pressure state. The fin includes a uniform channel that appears to be a braided channel structure of uniform configuration.

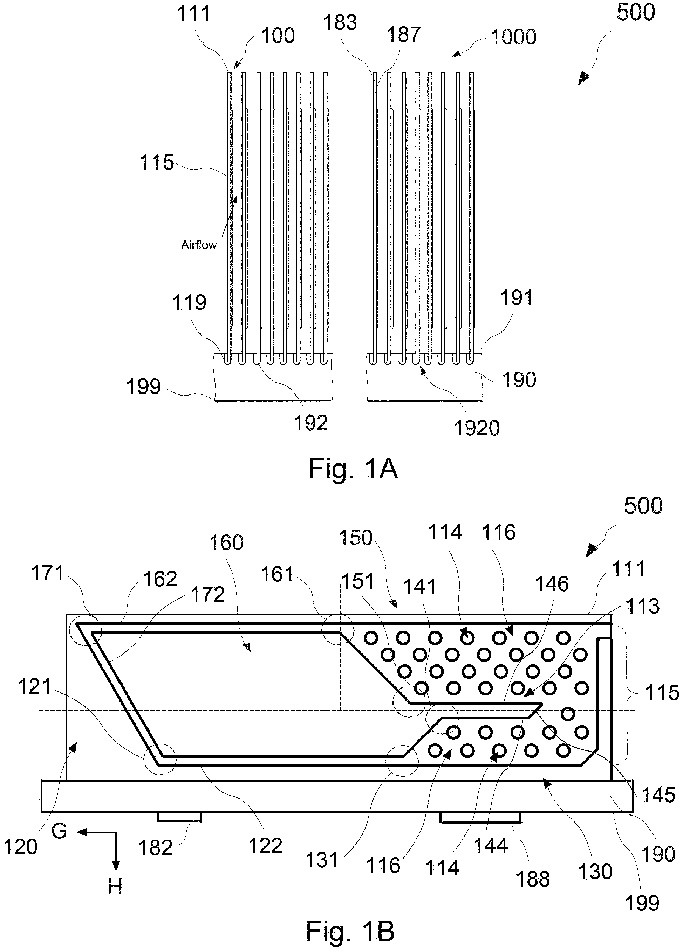

EP 3 550 947 A1 discloses a heat exchanger fin according to the preamble of claim 1 and relates to a heat sink including a base and a plurality of fins Each of the fins includes a root and a tip that are disposed opposite to each other. Each of the fins further includes a top and a bottom that are disposed opposite to each other and connected between the root and the tip. A heated area, a dropping pipe, and a spacing strip that separate the heated area from the dropping pipe are formed in the fin. The heated area is located between the root and spacing strip. The dropping pipe is located between the spacing strip and the tip. The first passage and a second passage are formed between the heated area and the dropping pipe. The first passage is located between spacing strip and the top, and the second passage is located between the spacing strip and bottom. At least the first passage and the second passage are honeycombed. In one embodiment (Figure 1), the pipelines in the heated area are also honeycombed. The working medium inside the fin is circulated from the heated area to the first passage, one or more dropping pipes and the second passage and then back to the heated area. The pipelines in the heated area and the pipelines of the dropping pipe are formed by using an extrusion molding technology or are formed by using a blow molding technology.

EP 2 677 261 A1 relates to a two-phase heat exchanger comprising an evaporator and a condenser for cooling at least one electronic and/or electric component. The condenser comprises roll-bonded panels connected or joined to the evaporator via connection ports, which connection ports comprise an inlet and/or outlet tube that allow the working fluid to flow from the evaporator body to the condenser body and vice versa. Both the first connection port and the second connection port are located at a common first edge approximate to a lateral edge of the roll-bonded panel, wherein the condenser panels are provided on an opposite end to the connection surface of the evaporator body. The first channel in the condenser and a second channel in the evaporator form a loop for guiding the working fluid in the heat exchanger. The first channel departs from the first connection port and comprises a first portion from where a plurality of third portions running parallel to one another branches off. All the third portions are fluidly connected to a single second portion, which in turn is fluidly connected to the second connection port. A plurality of longitudinal portions of the second channel discharge at their ends into a first manifold and a second manifold, respectively. Working fluid is allowed to rise in its vapor state from the first manifold to the first channel and the condensed working fluid is allowed to flow back to the second manifold in a liquid state.

DE 202 16 065 U1 refers to a heat sink which is a heat-absorbing base plate on which a plurality of cooling projections are attached at regular intervals. The cooling projections are internally designed as hollow bodies in order to lower the internal heat retention. Thermal energy is quickly transferred to the upper end of the cooling projections to allow rapid heat dissipation. The interior of the cooling projections can be vented in order to ensure even lower heat retention therein. Alternatively, the hollow cooling projections can be filled inside with thermally conductive material.

### SUMMARY

The present invention is defined by the features of claim 1, 12 and 13.

### BRIEF DESCRIPTION OF THE DRAWINGS

Unless specified otherwise, the accompanying drawings illustrate aspects of the innovative subject matter described herein. Referring to the drawings, wherein like reference numerals indicate similar parts throughout the several views, several examples of heat exchanger systems and methods incorporating aspects of the presently disclosed principles are illustrated by way of example, and not by way of limitation.
Fig. 1A is a schematic perspective second view of a heat exchanger, according to an example embodiment.
Fig. 1B is a schematic perspective first view of a heat exchanger, according to an example embodiment.
Fig. 2A is schematic perspective first view of a heat exchanger fin of the heat exchanger of Fig. 1A and Fig. 1B, according to an example embodiment.
Fig. 2B is schematic perspective third view of the heat exchanger fin of Fig. 2A, according to an example embodiment.
Fig. 3A is schematic perspective fourth view of an alternative heat exchanger fin, according to an example embodiment.
Fig. 3B is schematic perspective first view of the alternative heat exchanger fin of Fig. 3A, according to an example embodiment.
Fig. 4A is schematic perspective fourth view of another alternative heat exchanger fin, according to an example embodiment.
Fig. 4B is schematic perspective first view of the another alternative heat exchanger fin of Fig. 4A, according to an example embodiment.
Fig. 5A is schematic perspective fourth view of yet another alternative heat exchanger fin, according to an example embodiment.
Fig. 5B is schematic perspective first view of the yet another alternative heat exchanger fin of Fig. 5A, according to an example embodiment.
Fig. 6 is a flow chart illustrating a manufacturing method of the heat exchanger fin of Fig. 1A and Fig. 1B, according to an example embodiment.
Fig. 7A is schematic perspective fourth view of the heat exchanger fin of Fig. 1A and Fig. 1B following Step 630 of the manufacturing method of Fig. 6, according to an example embodiment.
Fig. 7B is schematic perspective first view of the heat exchanger fin of Fig. 7A following Step 660 of the manufacturing method of Fig. 6, according to an example embodiment.

### DETAILED DESCRIPTION

The following describes various principles related to heat exchanger systems and methods by way of reference to specific examples of heat exchanger systems and methods, including specific arrangements and examples of metal sheets, braided channels and obstructers embodying innovative concepts. More particularly, but not exclusively, such innovative principles are described in relation to selected examples of heat exchanger systems and methods and well-known functions or constructions are not described in detail for purposes of succinctness and clarity. Nonetheless, one or more of the disclosed principles can be incorporated in various other embodiments of heat exchanger systems and methods to achieve any of a variety of desired outcomes, characteristics, and/or performance criteria.

Thus, heat exchanger systems and methods having attributes that are different from those specific examples discussed herein can embody one or more of the innovative principles, and can be used in applications not described herein in detail. Accordingly, embodiments of heat exchanger systems and methods not described herein in detail also fall within the scope of this disclosure, as will be appreciated by those of ordinary skill in the relevant art following a review of this disclosure.

Example embodiments as disclosed herein are directed to heat exchangers and heat exchanger fins, under vacuum, and having a working fluid therein, and manufacturing methods of the heat exchanger fins. In an embodiment, a heat exchanger comprising a plurality of heat exchanger fins and a base plate is provided. Each heat exchanger fin comprises an exchanger enhancement having channels therein. The channels are formed by at least a first and second metal sheet. The channels are under vacuum and have a working fluid therein. The channels decrease the volume of working fluid employed and facilitates the creation of non-equilibrium pressure conditions, strengthening self-sustaining turbulent driving forces within each heat exchanger fin for heat dissipation. A portion of the channels more compatibly matches heat dissipation and thermal performance with heat dissipation requirements and thermal performance requirements of a lower-powered and lesser maximum operating temperature first heat source closer to ground and a higher-powered and greater maximum operating temperature allowance second heat source furthest away from ground.

Fig. 1A is a schematic perspective second view of a heat exchanger, according to an example embodiment. Fig. 1B is a schematic perspective first view of a heat exchanger, according to an example embodiment. The heat exchanger 500 may be employed to cool at least one of an electric and/or electronic element, device and/or system. Referring to Figs. 1A and 1B, the heat exchanger 500 comprises a plurality of heat exchanger fins 1000 and a base plate 190. Each heat exchanger fin 100 of the plurality of heat exchanger fins 1000 comprises a fin base 119, an exchanger enhancement 115, and a fin tip 111, opposite the fin base 119. The base plate 190 comprises a mounting surface 191 and a contact surface 199, opposite the mounting surface 191. The mounting surface 191 has a plurality of mounting grooves 1920 thereon, substantially parallel thereamong and evenly spaced apart.

The dimensions, depth, and amount of each mounting groove 192 of the plurality of mounting grooves 1920 correspond to the dimensions, height and amount of each fin base 119 of each heat exchanger fin 100. Each fin base 119 of each heat exchanger fin 100 may be thermally and mechanically, permanently attached to each mounting groove 192 by brazing techniques known to those of ordinary skill in the relevant art; however, the embodiments are not limited thereto. Other appropriate methods may be employed, as long as heat may be efficiently and effectively transferred from the base plate 190 to the plurality of heat exchanger fins 1000. In some embodiments, each fin base 119 may be hemmed, reinforcing the strength thereof and increasing the surface area for conductive heat transfer from the base plate 190 to the plurality of heat exchanger fins 1000.

The area occupied by the plurality of heat exchanger fins 1000 on the mounting surface 191 may be varied depending upon application and design requirements. As an example, the area may be smaller, resulting in a non-occupied area of the mounting surface 191 on one or more than one side thereof, or the area may be larger, extending outward over one or more side edges of the mounting surface 191, and the embodiments are not limited thereto.

One or more heat sources of electric and/or electronic elements, devices and/or systems, and/or any combination thereof, may be attached to the contact surface 199, for example and not to be limiting, by fastening or other means known to those of ordinary skill in the relevant art. As long as heat may be efficiently and effectively transferred from the one or more heat sources to the base plate 190.

In some embodiments, a first heat source 182 and a second heat source 188 is attached to the contact surface 199 of the base plate 190. The power requirement and maximum operating temperature allowance of the first heat source 182 is less than that of the second heat source 188 and when in operation, the first heat source 182 is closer to ground (G) than that of the second heat source 188.

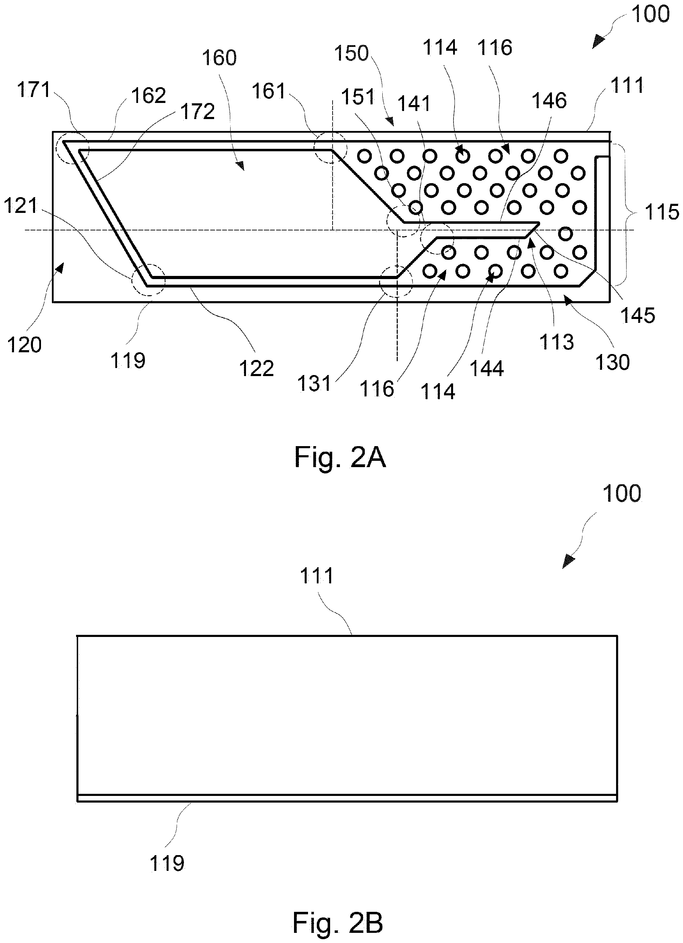

Fig. 2A is schematic perspective first view of a heat exchanger fin of the heat exchanger of Fig. 1A and Fig. 1B, according to an example embodiment. Fig. 2B is schematic perspective third view of the heat exchanger fin of Fig. 2A, according to an example embodiment. Referring to Figs. 2A and 2B, and referring to Figs. 1A and 1B, each heat exchanger fin 100 further comprises a first evaporator region 120, a second evaporator region 130, a first condenser region 160, and a second condenser region 150. An outer perimeter of the first and second evaporator regions 120, 130 is defined by the fin base 119 and an outer perimeter of the first and second condenser regions 160, 150 is defined by the fin tip 111. A lower outer perimeter of the first evaporator region 120 and lower outer perimeter of the first condenser region 160 is defined by a perimeter connecting first edges of the fin base 119 and fin tip 111, respectively, and an upper outer perimeter of the second evaporator region 130 and upper outer perimeter of the second condenser region 150 is defined by a perimeter connecting second edges of the fin base 119 and fin tip 111, respectively, opposite the first edges. The exchanger enhancement 115 comprises the first and second evaporator regions 120, 130 and first and second condenser regions 160, 150.

Each second evaporator region 130 and second condenser region 150 comprises a plurality of obstructers 114, forming braided channels 116 therearound, and at least a portion of a dividing obstructer 113 having a second evaporation side 144, a second condensation side 146 and a second flow side 145 connected to upper ends of the second evaporation side 144 and second condensation side 146, respectively. The second evaporation and condensation sides 144, 146, respectively, are generally parallel separated and defined by a second evaporation side start end 141, a second condensation side start end 151, and the connecting second flow side 145. The upper end of the second condensation side 146 is closer to the upper outer perimeter of the second condenser region 150 than the upper end of the second evaporation side 144 to the upper outer perimeter of the second evaporator region 130, facilitating vapor flow from the second evaporator region 130 to the second condenser region 150 and further increasing output pressure gain in downward working fluid flow of the at least one condensation channel 162. The dividing obstructer 113 defines a middle axis of the heat exchanger fin 100. The middle axis is generally parallel to the fin base 119, and is the middle plane between the furthest separation points of the second condensation side 146 and second evaporation side 144, respectively. The middle axis defines inner perimeters of the first evaporator region 120, second evaporator region 130, first condenser region 160, and second condenser region 150, respectively.

The plurality of obstructers 114 is generally circular-shaped having a staggered pitch; however, the embodiments are not limited thereto. Those of ordinary skill in the relevant art may readily appreciate that the shape and pitches of the plurality of obstructers 114 may be varied, such as hexagonal-shaped with larger and/or smaller and/or staggered and/or non-staggered pitches and/or any combination thereof, depending upon application and design requirements and the embodiments are not limited thereto. As long as the plurality of obstructers 114 form the braided channels 166 therearound.

Each first condenser region 160 comprises at least one condensation channel 162 and each first evaporator region 120 comprises at least one evaporation channel 122. The at least one condensation channel 162 is in communication with the plurality of obstructers 114 and braided channels 116 of the second condenser region 150 and the at least one evaporation channel 122 is in communication with the plurality of obstructers 114 and braided channels 116 of the second evaporator region 130. Each first condenser region 160 and each first evaporator region 130 further comprises at least a portion of at least one connecting channel 172 in communication with the at least one condensation channel 162 and at least one evaporation channel 122. A lower condensation channel end 171 of the at least one condensation channel 162 is defined by the connection between the at least one condensation channel 162 and the connecting channel 172 and a lower evaporation channel end 121 of the at least one evaporation channel 122 is defined by the connection between the at least one evaporation channel 122 and the connecting channel 172. The lower evaporation channel end 121 is further away from ground than the lower condensation channel end 171, assisting the working fluid from the downward working fluid flow to be driven upward into the second evaporator region 130 from the at least one evaporation channel 122. An upper condensation channel end 161 of the at least one condensation channel 162 is defined by the connection between the at least one condensation channel 162 and the braided channels 116 of the second condenser region 150 and an upper evaporation channel end 131 of the at least one evaporation channel 122 is defined by the connection between the at least one evaporation channel 122 and the braided channels 116 of the second evaporator region 130. The upper condensation channel end 161 defines a condenser partition between the first and second condenser regions 170, 160, perpendicular to the middle axis inner perimeter, and the upper evaporation channel end 131 defines an evaporator partition between the first and second evaporator regions 120, 130, perpendicular to the middle axis inner perimeter.

The first evaporator region 120 is defined by a portion of the connecting fin base 119 and fin tip 111 edges lower outer perimeter, a portion of the fin base 119 outer perimeter, a portion of the middle axis inner perimeter, and the upper evaporation channel end 131 evaporator partition, the second condenser region 160 is defined by a portion of the connecting fin base 119 and fin tip 111 edges lower outer perimeter, a portion of the fin tip 111 outer perimeter, a portion of the middle axis inner perimeter, and the upper condenser channel end 161 condenser partition, the second evaporator region 130 is defined by a portion of the connecting fin base 119 and fin tip 111 edges upper outer perimeter, a portion of the fin base 119 outer perimeter, a portion of the middle axis inner perimeter, and the upper evaporation channel end 131 evaporator partition, and the second condenser region 150 is defined by a portion of the connecting fin base 119 and fin tip 111 edges upper outer perimeter, a portion of the fin tip 111 outer perimeter, a portion of the middle axis inner perimeter, and the upper condenser channel end 161 condenser partition.

In some embodiments, there is one at least one condensation channel 162, one at least one evaporation channel 122, and one at least one connecting channel 172; however, the embodiments are not limited thereto. In alternative embodiments, there may be two or more at least one condensation channel 162 and/or two or more at least one evaporation channel 122 and/or two or more at least one connecting channel 172, or any combination amounts thereof. As an example, there may be two at least one condensation channels communicating with at least one connecting channel or there may be two at least one connecting channels communicating with at least one condensation channel and at least one evaporation channel. As long as the two or more at least one condensation channel 162 is in direct or indirect communication with the plurality of obstructers 114 and braided channels 116 of the second condenser region 150, the two or more at least one evaporation channel 122 is in direct or indirect communication with the plurality of obstructers 114 and braided channels 116 of the second evaporator region 130, and the two or more at least one connecting channel 172 is in direct or indirect communication with the two or more at least one condensation channel 162 and two or more at least one evaporation channel 122.

In some embodiments, the flow volume of the at least one condensation channel 162, at least one evaporation channel 122, and at least one connecting channel 172 is generally even thereacross, respectively; however, the embodiments are not limited thereto. Those of ordinary skill in the relevant art may readily appreciate that the vertical and horizontal dimensions may be varied, respectively, depending upon application and design requirements. As long as the at least one condensation channel 162 is in direct or indirect communication with the second condenser region 150, the at least one evaporation channel 122 is in direct or indirect communication with the second evaporator region 130, and the at least one connecting channel 172 is in direct or indirect communication with the at least one condensation channel 162 and at least one evaporation channel 122.

Each of the heat exchanger fins 100 further comprise at least a first metal sheet 183 and at least a second metal sheet 187, forming the fin base 119 and fin tip 111, and exchanger enhancement 115 comprising at least one condensation channel 162, at least one connecting channel 172, at least one evaporation channel 122, a dividing obstructer 113, plurality of obstructers 114 and braided channels 116. The at least a first metal sheet 183 comprises a first inner surface and the at least a second metal sheet 187 comprises a second inner surface. The second inner surface comprises the fin base 119, exchanger enhancement 115, fin tip 111, at least one condensation channel 162, at least one connecting channel 172, at least one evaporation channel 122, a dividing obstructer 113, plurality of obstructers 114 and braided channels 116.

In some embodiments, each of the plurality of heat exchanger fins 1000, is under vacuum, and has a working fluid therein. The working fluid is distributed naturally in the form of liquid vapor slugs/bubbles throughout the braided channels 116. Each heat exchanger fin 100 comprises a main evaporator region (second evaporator region 130), a main condenser region (second evaporator region 150), vapor flow braided channels 116 extending from the main evaporator and condenser regions, respectively, and directed working fluid condenser channels (at least one condensation channel 162), directed working fluid transport channels (at least one connecting channel 172), and directed working fluid evaporator channels (at least one evaporation channel 122). When heat from at least a first heat source 182 and at least a second heat source 188 is applied to the perimeter of the first and second evaporator regions 120, 130, respectively (each fin base 119), the heat converts the working fluid to vapor and the vapor bubbles become larger within the second evaporator region 130. Meanwhile, at the second condenser region 150, heat is being removed and the bubbles are reducing in size. The volume expansion due to vaporization and the contraction due to condensation cause an oscillating motion within the channels (braided channels 116, at least one condensation channel 162, at least one connecting channel 172, and at least one evaporation channel 122). The volume of the second condenser region 150 is at least equal to or greater than the volume of the second evaporator region 130, facilitating the oscillating motion. The net effect of the temperature gradient between the second evaporator region 130 and second condenser region 150 and the tensions introduced throughout the braided channels 116 and directed working fluid channels (at least one condensation channel 162, at least one connecting channel 172, and at least one evaporation channel 122) creates a non-equilibrium pressure condition. The increased output pressure gain in downward working fluid flow to the at least one condensation channel 162, boosts upward oscillation driving forces throughout the at least one connecting channel 172 and at least one evaporation channel 122, and thus improves the decreasing heat transfer efficiency rate along each fin edge 119 for electric and/or electronic elements, devices and systems that operate vertically, improving thermal performance. The lower evaporation channel end 121 is further away from ground than the lower condensation channel end 171 to facilitate the working fluid from the downward working fluid flow to be driven upward into the second evaporator region 130 from the at least one evaporation channel 122. Thermo-fluidic transport is provided within each heat exchanger fin 100 via the self-sustaining oscillation driving forces, whereby the pressure pulsations are fully thermally driven.

Thus, when an optimal filling ratio is of between around 40% to 80%, via the at least one condensation channel 162, at least one connecting channel 172, and at least one evaporation channel 122, and braided channels 116 of the second evaporator region 130 and second condenser region 150, respectively, the amount of working fluid for efficient and effective thermal performance is reduced by 40% to 60% when compared to a heat exchanger that does not comprise the at least one condensation channel 162, at least one connecting channel 172, and at least one evaporation channel 122, and braided channels 116 of the second evaporator region 130 and second condenser region 150. Weight of the plurality of heat exchanger fins 1000 is reduced, eliminating the need for more costly attachment materials or non-standard attachment mechanisms. Furthermore, via the at least one evaporation channel 122 and braided channels 116 of the evaporator region 130, a greater amount of working fluid is contained in the evaporator region 130 further away from ground. Thus, heat dissipation efficiency is driven upward, opposite the direction of gravity, mitigating dry-out from occurring, causing the electric and/or electronic elements, devices and/or systems to overheat, fail or be damaged. Even more, the lesser maximum operating temperature allowance for lower-powered electric and/or electronic elements and/or devices is more compatibly met via the at least one evaporation channel 122 and the greater maximum operating temperature allowance for lower-powered electric and/or electronic elements and/or devices is more compatibly met via the upward driven increase in heat dissipation efficiency. When there are more than one than one heat source, as an example, three heat sources, a first heat source, a second heat source, and a third heat source between the first and second heat sources, heat dissipation efficiency is increased for the second heat source, closest to the upper outer perimeters of the second evaporator region 130 and second condenser region 150, when compared to a heat exchanger that does not comprise the at least one condensation channel 162, at least one connecting channel 172, and at least one evaporation channel 122, and braided channels 116 of the second evaporator region 130 and second condenser region 150. Thus, the electric and/or electronic elements, devices and/or systems are mitigated from overheating, failing or being damaged via the more compatible matching of heat dissipation efficiency and power output and maximum heat tolerance of the heat sources attached to the contact surface 199 of the base plate 190.

Those of ordinary skill in the relevant art may readily appreciate that the shape and width of the dividing obstructer 113, and lengths of the second evaporation and condensation sides 144, 146 may be varied, such as having a wavy shape, having larger or smaller widths and having longer or shorter sides, respectively, and/or any combination thereof, depending upon application and design requirements and the embodiments are not limited thereto. As long as the second flow side 145 upper end of the second condensation side 146 is closer to the upper outer perimeters of the second evaporator region 130 and second condenser region 150 than the second flow side 145 upper end of the second evaporation side 144, respectively, and the volume of the braided channels 116 of the second condenser region 150 is at least equal to or greater than the volume of the braided channels 116 of the second evaporator region 130.

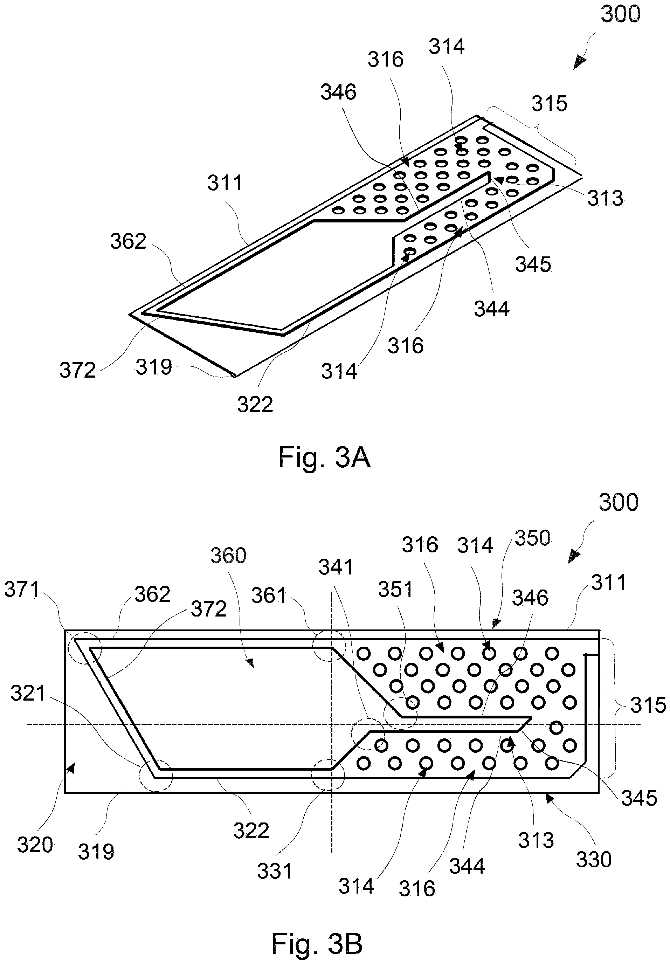

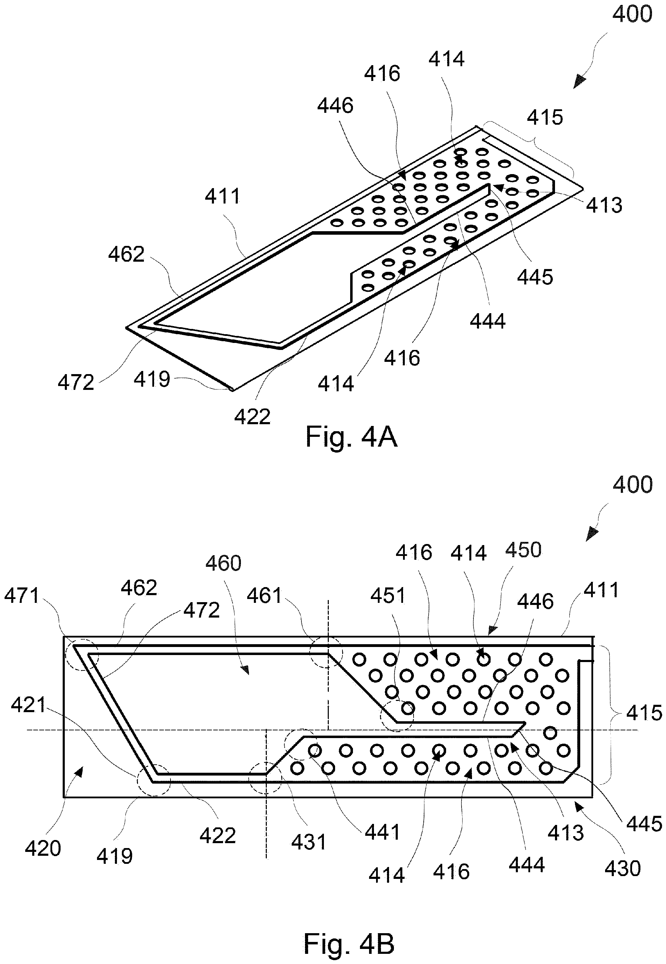

Fig. 3A is schematic perspective fourth view of an alternative heat exchanger fin 300, according to an example embodiment. Fig. 3B is schematic perspective first view of the alternative heat exchanger fin 300 of Fig. 3A, according to an example embodiment. Referring to Figs 3A and 3B, and referring to Figs. 1A to 2B, in an alternative heat exchanger fin 300, the length of the second evaporation side 344 of the dividing obstructer 313 is lengthen to be longer than the length of the second condensation side 346. Thus, for electric and/or electronic elements, devices and systems that operate vertically, greater heat dissipation efficiency is moved closer to ground for compatible matching of a heat source having a power output and maximum heat tolerance also closer to ground, whereby the contact surface 199 of the base plate 190 attachment is therenearby. The second flow side 345 upper end of the second condensation side 346 is closer to the upper outer perimeters of the second evaporator region 330 and second condenser region 350 than the second flow side 345 upper end of the second evaporation side 344, respectively, and the volume of the braided channels 316 of the second condenser region 350 is at least equal to or greater than the volume of the braided channels 316 of the second evaporator region 330. Fig. 4A is schematic perspective fourth view of another alternative heat exchanger fin, according to an example embodiment. Fig. 4B is schematic perspective first view of the another alternative heat exchanger fin of Fig. 4A, according to an example embodiment. Referring to Figs 4A and 4B, and referring to Figs. 1A to 3B, in another alternative heat exchanger fin 400, the length of the second evaporation side 444 of the dividing obstructer 413 is lengthen to be even longer than the length of the second condensation side 446. Thus, for electric and/or electronic elements, devices and systems that operate vertically, greater heat dissipation efficiency is moved even closer to ground for compatible matching of a heat source having a power output and maximum heat tolerance also closer to ground, whereby the contact surface 199 of the base plate 190 attachment is therenearby. The second flow side 445 upper end of the second condensation side 446 is closer to the upper outer perimeters of the second evaporator region 430 and second condenser region 450 than the second flow side 445 upper end of the second evaporation side 444, respectively, and the volume of the braided channels 416 of the second condenser region 450 is at least equal to or greater than the volume of the braided channels 416 of the second evaporator region 430. Other features and principles of the alternative heat exchanger fin 300 and another alternative heat exchanger fin 400 are generally the same as and described in detail in the embodiments of the heat exchanger fin 100 above, and for sake of brevity, will not repeated hereafter.

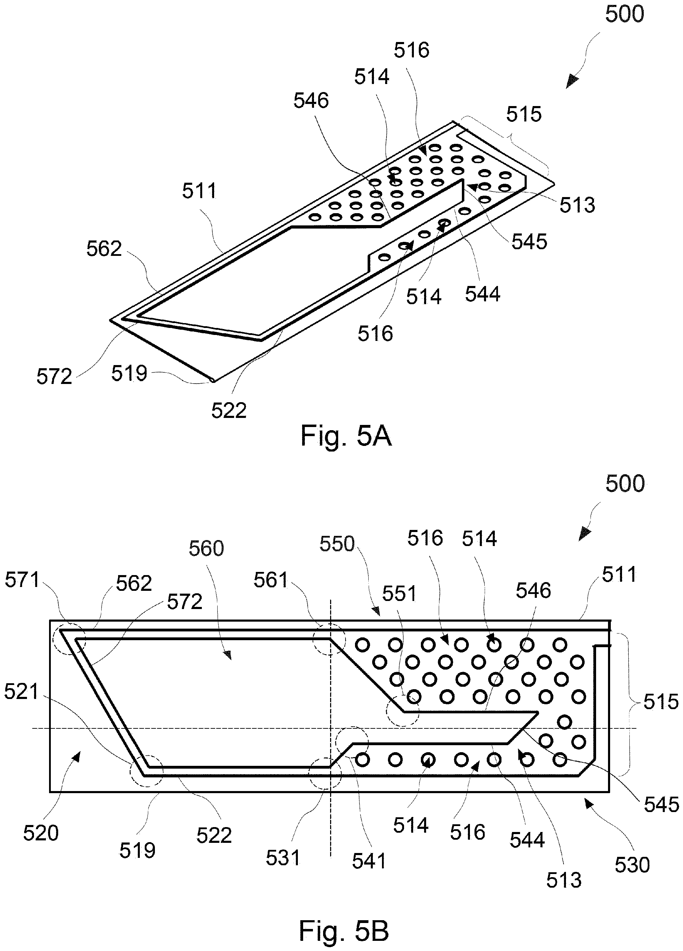

Fig. 5A is schematic perspective fourth view of yet another alternative heat exchanger fin 500, according to an example embodiment. Fig. 5B is schematic perspective first view of the yet another alternative heat exchanger fin 500 of Fig. 5A, according to an example embodiment. Referring to Figs 5A and 5B, and referring to Figs. 1A to 4B, in yet another alternative heat exchanger fin 500, the length of the second evaporation side 544 of the dividing obstructer 513 is lengthen to be longer than the length of the second condensation side 546 and the width of the dividing obstructer 513 is widened to decrease the braided channels 516 of the second evaporator region 530. Thus, for electric and/or electronic elements, devices and systems that operate vertically, greater heat dissipation efficiency is moved closer to ground for compatible matching of a heat source having a power output and maximum heat tolerance also closer to ground, whereby the contact surface 199 of the base plate 190 attachment is therenearby, and heat dissipation efficiency is lessened for compatible matching of heat sources having lesser power output and maximum heat tolerances, thereby further decreasing working fluid volume and weight of the yet another alternative heat exchanger fin 500. The second flow side 545 upper end of the second condensation side 546 is closer to the upper outer perimeters of the second evaporator region 530 and second condenser region 550 than the second flow side 545 upper end of the second evaporation side 544, respectively, and the volume of the braided channels 516 of the second condenser region 550 is at least equal to or greater than the volume of the braided channels 516 of the second evaporator region 530. Other features and principles of the yet another alternative heat exchanger fin 500 are generally the same as and described in detail in the embodiments of the heat exchanger fin 100 above, and for sake of brevity, will not repeated hereafter.

The plurality of heat exchanger fins 1000, under vacuum, having a working fluid in the braided channels 116, compatibly matches heat dissipation and thermal performance with heat dissipation requirements and thermal performance requirements of more than one heat source attached to the contact surface 199 of the base plate 190; solid heat exchanger fins do not. The at least one condensation channel 162, 362, 462, 562, at least one connecting channel 172, 372, 472, 572, and at least one evaporation channel 122, 322, 422, 522, braided channels 116, 316, 416, 516, formed by the staggered pitch plurality of obstructers 114, 314, 414, 514, and dividing obstructer 113, 313, 413, 513, increases the creation of non-equilibrium pressure conditions, strengthening the self-sustaining turbulent driving forces within the at least one condensation channel 162, 362, 462, 562, at least one connecting channel 172, 372, 472, 572, and at least one evaporation channel 122, 322, 422, 522, and braided channels 116, 316, 416, 516. Furthermore, insulating blanket layers around heat source walls are prevented from forming and restricting heat transfer.

In some embodiments, the first and second inner surfaces of the first and second metal sheets 183, 187, respectively, are bonded together and integrally formed at areas other than the at least one condensation channel 162, 362, 462, 562, at least one connecting channel 172, 372, 472, 572, and at least one evaporation channel 122, 322, 422, 522, and dividing obstructer 113, 313, 413, 513 and braided channels 116, 316, 416, 516 formed areas, and the embodiments are not limited thereto.

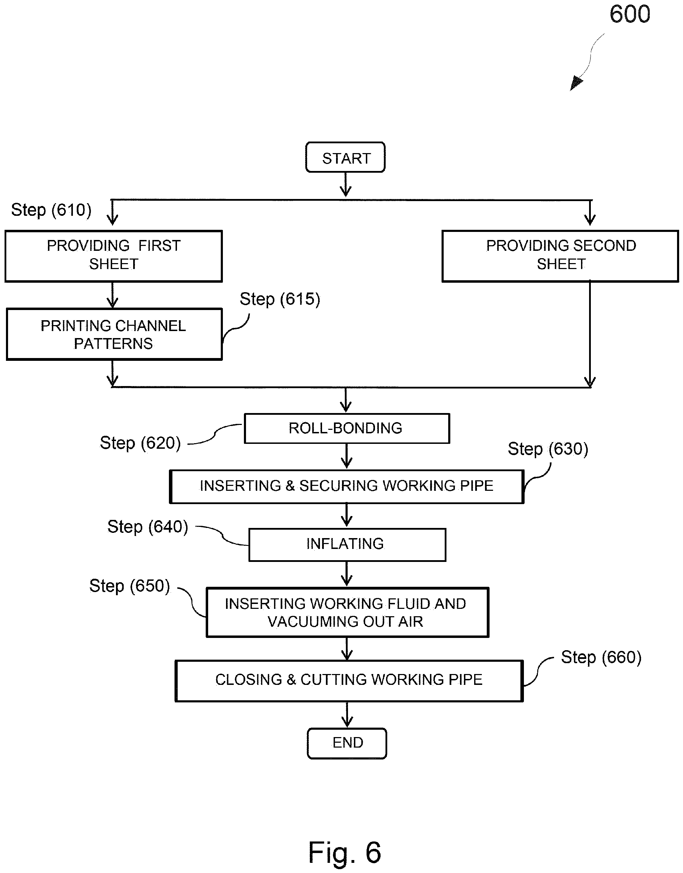

In some embodiments, each heat exchanger fin 100 is made of aluminum, or an aluminum-alloy or the like, and formed by roll-bonding. Fig. 6 is a flow chart illustrating a manufacturing method 600 of the heat exchanger fin 100 of Fig. 2A, according to an example embodiment. Referring to Fig. 6, and referring to Figs. 1A to 5B, the method 600 of manufacturing each heat exchanger fin 100, under vacuum, having a working fluid therein, generally comprises a providing Step 610, a pattern printing Step 615, a roll-bonding Step 620, an inflating Step 640, an inserting and vacuuming Step 650 and a closing and cutting Step 660. The first step, Step 610, comprises providing at least a first metal sheet and at least a second metal sheet. In some embodiments, the at least a first and second metal sheets are metal coils, unrolled through an unwinder and then aligned by a suitable roller stand. Next, in Step 615, a pattern of at least one condensation channel, at least one connecting channel, and at least one evaporation channel, and braided channels are printed on the at least a first metal sheet. In some embodiments, the sheets are cleaned and then printed by a screen printing process employing a graphite pattern of the braided channels. In some embodiments, each heat exchanger fin 100 further comprises a working channel 916 of a working section 918, extending from one end of the braided channels 116 to an outer edge of each heat exchanger fin 100. In some embodiments, the screen printing process employing the graphite pattern also prints the extended working channel 916. Following, in Step 520, the first inner surface of the at least first metal sheet and second inner surface of the at least second metal sheet are integrally bonded in areas other than the channels printed areas.

Those of ordinary skill in the relevant art may readily appreciate that the use of graphite serves as a release agent, thus, preventing the at least first and second metal sheets from integrally bonding in at least the areas of the applied patterned braided channels; however, the embodiments are not limited thereto. Any type of method or material may be employed as known and common for those skilled in the relevant art to serve as the release agent. As long as the at least first and second metal sheets are prevented from integrally bonding in the at least areas of the applied braided channels following the roll-bonding step.

In some embodiments, the thickness of the at least a first and second metal sheets is between around 0.250 mm and 3.00 mm, having a reduction of each of the at least a first and second metal sheets between around 40% to 60%; however, the embodiments are not limited thereto. Those of ordinary skill in the relevant art may readily appreciate that thicknesses and reduction of each of the at least a first and second metal sheets can be more or less, depending upon the material, starting thickness, amount of sheets, processes employed, and design requirements for effective and efficient thermal performance.

In some embodiments, the shape of each heat exchanger fin 100 is quadrilateral shaped; however, the embodiments are not limited thereto. Those of skill in the relevant art may readily appreciate that each heat exchanger fin may be of a shape other than quadrilateral shaped, and may be made up of more than one shape according to application and design requirements. As long as the at least one condensation channel, at least one connecting channel, and at least one evaporation channel, and braided channels increases the creation of non-equilibrium pressure conditions, strengthening the self-sustaining turbulent driving forces within the at least one condensation channel, at least one connecting channel, and at least one evaporation channel, and braided channels, more compatibly matching heat dissipation and thermal performance with heat dissipation requirements and thermal performance requirements of a lower-powered and lesser maximum operating temperature first heat source attached to the heat exchanger 500 closer to ground and a higher-powered and greater maximum operating temperature allowance second heat source attached to the heat exchanger 500 furthest away from ground.

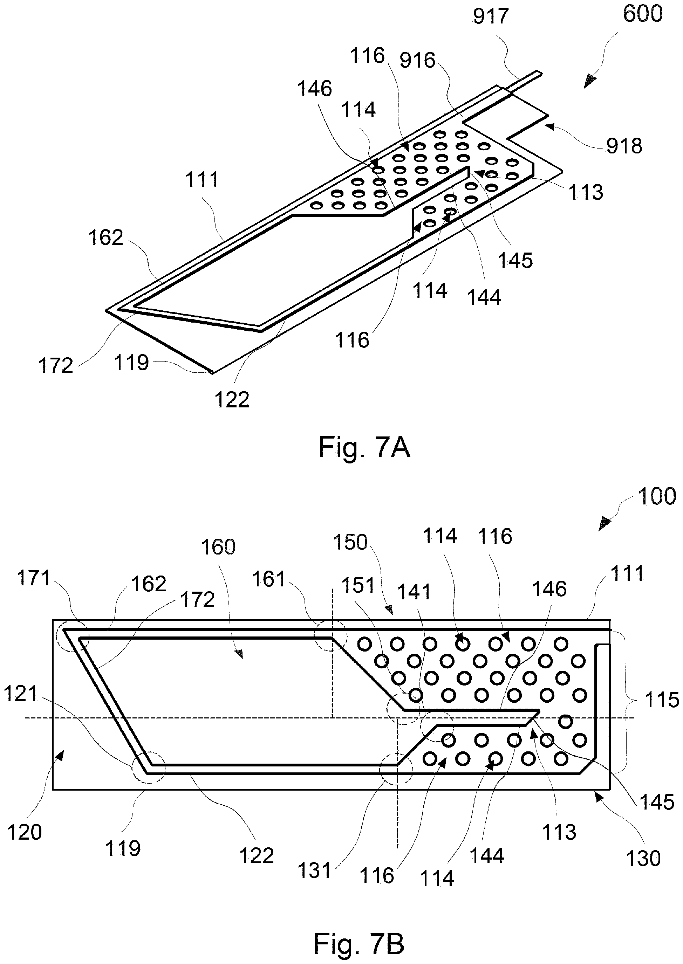

Fig. 7A is schematic perspective fourth view of the heat exchanger fin of Fig. 1A and Fig. 1B following Step 630 of the manufacturing method of Fig. 6, according to an example embodiment. Referring to Fig. 7A, and referring to Figs. 1A to 5, next, in Step 630 a working pipe 917 is inserted and secured to the working channel 916, extending from the one end of the braided channels 116 to an outer edge of each heat exchanger fin 100. The working pipe allows for communication with the outside atmosphere and the at least one condensation channel, at least one connecting channel, and at least one evaporation channel, and braided channels. Following, in Step 640, the channels are inflated via a gas having a pressure configured for even inflation throughout each heat exchanger fin 100. In some embodiments, the gas is atmospheric air having a suitable pressure for inflation; however, the embodiments are not limited thereto. In alternative embodiments, the gas may be nitrogen, oxygen, argon, hydrogen, carbon dioxide, or any of the commonly available commercial gasses or compatible mixtures thereof. In some embodiments, the at least a first and second metal sheet 183, 187 is inserted into a mold before inflating for even inflation throughout each heat exchanger fin 100.

In some embodiments, the height or radius of the at least one condensation channel, at least one connecting channel, and at least one evaporation channel, and braided channels from a cross-section is between around 0.125 mm and 1.50 mm; however, the embodiments are not limited thereto. Those of ordinary skill in the relevant art may readily appreciate that the height or radius of the at least one condensation channel, at least one connecting channel, and at least one evaporation channel, and braided channels can be larger or smaller and/or varied, or any combination thereof, depending upon the material, starting thickness, amount of sheets, processes employed, and design requirements for effective and efficient thermal performance.

Next, in Step 650 a working substance is inserted into the working pipe and then air is vacuumed out. Fig. 7B is schematic perspective first view of the heat exchanger fin of Fig. 7A following Step 660 of the manufacturing method of Fig. 6, according to an example embodiment. Referring to Fig. 7B, and referring to Figs. 1A to 7A, in Step 660, the working pipe 917 is closed and sealed by flattening and then bonding thereof, and after cooling, the working channel 916 the working section 918 comprising the working channel 916 and the working pipe 917 is cut, forming each heat exchanger fin 100 comprising the at least one condensation channel, at least one connecting channel, and at least one evaporation channel, and braided channels.

In some embodiments, the diameter of the plurality of obstructers 114 is the same and between around 0.500 mm and 6.00 mm; however, the embodiments are not limited thereto. Those of ordinary skill in the relevant art may readily appreciate that the diameter of the plurality of obstructers 114 can be larger or smaller, depending upon the material, starting thickness, amount of sheets, and design requirements for effective and efficient thermal performance. As long as the braided channels 116 formed by the staggered pitch plurality of obstructers 114 increases the creation of the non-equilibrium pressure condition within the braided channels 116, strengthening the self-sustaining turbulent driving forces therein.

In some embodiments, the at least a first metal sheet 183 and at least a second metal sheet 187 are made of aluminum, or an aluminum-alloy or the like, and formed by roll-bonding; however, the embodiments are not limited thereto. Those of ordinary skill in the relevant art may readily appreciate that other manufacturing processes may be employed to form the at least a first metal sheet 183 and at least a second metal sheet 187, such as stamping, depending upon material and manufacturing requirements. Those of ordinary skill in the relevant art may also readily appreciate that the at least a first metal sheet 183 and at least a second metal sheet 187 may be made of copper, or a copper-alloy or the like, or other malleable metal heat conducting material having a relatively high thermal conductivity depending upon application and design requirements. As long as each heat exchanger fin 100 may be formed by roll-bonding or stamping, or the like.

In some embodiments, the base plate 190 is made of aluminum, or an aluminum-alloy or the like and suitable for utilizing a brazing technique for thermal and mechanical, permanent brazing of each fin base 119 of each heat exchanger fin 100 to each mounting groove 192; however, the embodiments are not limited thereto. The base plate 190 may also be made of copper, or a copper-alloy or the like, or other malleable metal heat conducting material having a relatively high thermal conductivity depending upon application and design requirements. As long as each fin base 119 may be thermally and mechanically, permanently mounted to each mounting groove 192.

In some embodiments, the base plate 190 is made of a solid malleable metal heat conducting material having a relatively high thermal conductivity; however, the embodiments are not limited thereto. In alternative embodiments, the base plate 190 is under vacuum, and has a working fluid therein. In yet further alternative embodiments, the base plate 190 has an inlet and an outlet, having working fluid flowing therein and thereabout.

In some embodiments, if a stamping process or the like is used to form each heat exchanger fin 100 any bonding method known by those skilled in the relevant art, such as ultrasonic welding, diffusion welding, laser welding and the like, can be employed to bond and integrally form the first and second inner surfaces together at areas other than the formed areas of the at least one condensation channel, at least one connecting channel, and at least one evaporation channel, and braided channels. As long as a vacuum seal can be achieved.

In some embodiments, if a stamping process or the like is employed, depending upon dimensions and application, axial or circumferential wick structures, having triangular, rectangular, trapezoidal, reentrant, etc. cross-sectional geometries, may be formed on inner surfaces of the at least one condensation channel, at least one connecting channel, and at least one evaporation channel, and braided channels. The wick structure may be used to facilitate the flow of condensed fluid by capillary force back to the evaporation surface, keeping the evaporation surface wet for large heat fluxes.

Those of ordinary skill in the relevant art may readily appreciate that in alternative embodiments, further heat treatment processes can be employed throughout the manufacturing method of each heat exchanger fin 100, and the embodiments are not limited to those described. Additionally, those skilled in the relevant art may readily appreciate that additional steps can be added to the process in order to incorporate additional features into the finished product. Also, the steps can be altered depending upon different requirements. As examples, and not to be limiting: preparatory steps of alloying, casting, scalping and pre-heating: intermediate steps such as intermediate annealing; and finishing steps such as solution heat treatment or final annealing, stretching, leveling, slitting, edge trimming and aging, and the like may be employed.

In some embodiments, each heat exchanger fin 100 comprises a one sided inflated roll-bonded sheet having the at least one condensation channel, at least one connecting channel, and at least one evaporation channel, and braided channels; however, the embodiments are not limited thereto. In alternative embodiments, each heat exchanger fin 100 may comprise the at least one condensation channel, at least one connecting channel, and at least one evaporation channel, and braided channels on two sides thereof via two one sided inflated roll-bonded sheets. In yet further alternative embodiments, each heat exchanger fin 100 comprising the one sided inflated roll-bonded sheet having the at least one condensation channel, at least one connecting channel, and at least one evaporation channel, and braided channels, may be employed as a stand-alone heat exchanger, and the embodiments are not limited thereto.

In some embodiments, the working fluid is made of acetone; however, the embodiments are not limited thereto. Other working fluids can be employed, as can be common for those skilled in the relevant art. As a non-limiting example, the working fluid can comprise cyclopentane or n-hexane. As long as the working fluid can be vaporized by a heat source and the vapor can condense back to the working fluid and flow back to the heat source.

A heat exchanger 500 comprising a plurality of heat exchanger fins 1000 and a base plate 190 is provided. Each heat exchanger fin 100 of the plurality of heat exchanger fins 1000 comprises an exchanger enhancement 115 having at least one condensation channel 162, at least one connecting channel 172, and at least one evaporation channel 122, and a plurality of obstructers 114, forming braided channels 116 therearound. The braided channels 116 are formed by at least a first metal sheet 183 and at least a second metal sheet 187 of each heat exchange fin 100. The at least one condensation channel 162, at least one connecting channel 172, and at least one evaporation channel 122, and braided channels 116 are under vacuum and have a working fluid therein. The at least one condensation channel 162, at least one connecting channel 172, and at least one evaporation channel 122, and braided channels 116 increase the creation of non-equilibrium pressure conditions, strengthening the self-sustaining turbulent driving forces therewithin, more compatibly matching heat dissipation and thermal performance with heat dissipation requirements and thermal performance requirements of a lower-powered and lesser maximum operating temperature first heat source 182 attached to the heat exchanger 500 closer to ground and a higher-powered and greater maximum operating temperature allowance second heat source 188 attached to the heat exchanger 500 furthest away from ground.

In the embodiments, a plurality of heat exchanger fins, under vacuum, having a working fluid therein, each comprising at least a first metal sheet and at least a second metal sheet are provided. The at least a first and second metal sheet form a fin base and a fin tip, and an exchanger enhancement comprising at least one condensation channel, at least one connecting channel, at least one evaporation channel, a dividing obstructer, plurality of obstructers and braided channels of each heat exchanger fin of the plurality of heat exchanger fins of a heat exchanger. Each heat exchanger fin, under vacuum, has a working fluid in the at least one condensation channel, at least one connecting channel, and at least one evaporation channel, and braided channels, increasing heat dissipation and thermal performance thereof when compared to solid heat exchanger fins via the increased creation of non-equilibrium pressure conditions, strengthening the self-sustaining turbulent driving forces therewithin. Thus, insulating blanket layers around heat source walls are prevented from forming and restricting heat transfer. Also, due to the channels, the volume of working fluid is decreased, decreasing the weight of the closed-looped enhancement, thus, decreasing the requirement for more costly attachment materials or non-standard attachment mechanisms for one or more heat source attachment. Furthermore, decreasing heat transfer efficiency of the closed-looped enhancement at a greater and greater rate along the mounted surface of the heat exchanger the further the mounted surface is away from ground due to the inefficiency of the working fluid to rise against the direction of gravity is improved via the volume of braided channels of the condenser region being at least equal to or larger than the volume of braided channels of the evaporator region, increasing output pressure gain in downward working fluid flow, boosting upward oscillation driving forces throughout the at least one connecting channel and at least one evaporation channel to the braided channels of the evaporator region. Even more, for electric and/or electronic elements, devices and systems that operate vertically, having lower-powered electric and/or electronic elements and/or devices positioned closer to ground versus higher powered electric and/or electronic elements and/or devices due to rising of higher temperature air, the largest heat dissipation efficiency of each heat exchanger fin is not closer to ground, where a majority of working fluid agglomerates due to gravity, but, further from ground. Thus, more compatible matching of heat dissipation and thermal performance is achieved with heat dissipation requirements and thermal performance requirements of a lower-powered and lesser maximum operating temperature first heat source closer to ground and a higher-powered and greater maximum operating temperature allowance second heat source further away from ground.

The presently disclosed inventive concepts are not intended to be limited to the embodiments shown herein, but are to be accorded their full scope consistent with the appended claims Directions and references to an element, such as "up," "down,", "upper," "lower," "horizontal," "vertical," "left," "right," and the like, do not imply absolute relationships, positions, and/or orientations. In the sense of this application "vertical" does mean in a range of ± 15°, preferably ± 7.5° to vertical. Terms of an element, such as "first" and "second" are not literal, but, distinguishing terms. As used herein, terms "comprises" or "comprising" encompass the notions of "including" and "having" and specify the presence of elements, operations, and/or groups or combinations thereof and do not imply preclusion of the presence or addition of one or more other elements, operations and/or groups or combinations thereof. Sequence of operations do not imply absoluteness unless specifically so stated. Reference to an element in the singular, such as by use of the article "a" or "an", is not intended to mean "one and only one" unless specifically so stated, but rather "one or more". As used herein, "and/or" means "and" or "or", as well as "and" and "or." As used herein, ranges and subranges mean all ranges including whole and/or fractional values therein and language which defines or modifies ranges and subranges, such as "at least," "greater than," "less than," "no more than," and the like, mean subranges and/or an upper or lower limit.

## Claims

1. A heat exchanger fin (100) having a working fluid therein, comprising a channel system having subsequent regions (120, 130, 160, 150) and configured such that a fully thermally driven subsequent flow of the working fluid through the subsequent regions (120, 130, 160, 150) in a closed loop configuration is producible, wherein the heat exchanger fin (100) is under vacuum, the subsequent regions at least comprise a first evaporator region (120), a second evaporator region (130), a first condenser region (160), and a second condenser region (150), **characterised in that** the first evaporator region (120) is configured differently from the second evaporator region (130) and the first condenser region (160) is configured differently from the second condenser region (150), that the second evaporation region (130) and the second condenser region (150) each comprise a plurality of obstructers (114) forming braided channels (116) there around, and that the second evaporator region (130) and the second condenser region (150) are at least partially separated from another by a dividing obstructer (113) having a flow side (145) forming at least a part of the fluid flow connection between the second evaporator region (130) and the second condenser region (150).

2. The heat exchanger fin (100) of claim 1, wherein the volume of the second condenser region (150) is at least equal to or greater than the volume of the second evaporator region (130).

3. The heat exchanger fin (100) of claim 1 or 2, wherein the first condenser region (160) comprises at least one condensation channel (162) forming at least a part of a fluid flow connection between the second condenser region (150) and the first evaporator region (120), and the first evaporator region (120) comprises at least one evaporation channel (122) forming at least a part of a fluid flow connection between the first condenser region (160) and the second evaporator region (130).

4. The heat exchanger fin (100) of one of claims 1 to 3, wherein the dividing obstructer (113) has an evaporation side (144) facing the second evaporator region (130) and a condensation side (146) facing the second condenser region (150), whereby the flow side (145) connects free ends of the evaporation side (144) and the condensation side (146) and whereby the flow cross-section of the fluid flow connection between the second evaporator region (130) and the second condenser region (150) at least partially decreases toward the second condenser region (150).

5. The heat exchanger fin (100) of one of claims 1 to 4, wherein the dividing obstructer (113) defines a middle axis of the heat exchanger fin (100), whereby the middle axis defines inner perimeters of the first evaporator region (120), second evaporator region (130), first condenser region (160), and second condenser region (150), respectively.

6. The heat exchanger fin (100) of claim 5, wherein the at least one condensation channel (162) is connected to the at least one evaporation channel (122) by at least one connection channel (172), whereby the at least one connection channel (172) runs substantially oblique to the middle axis.

7. The heat exchanger fin (100) of claim 5 or 6, wherein the middle axis is oriented substantially vertical, namely in a range ± 15°, preferably in a range ± 7.5° to vertical, when the heat exchanger fin (100) is in use.

8. The heat exchanger fin (100) of claim 7, wherein the at least one connection channel (172) runs substantially upward from the at least one condensation channel (162) to the at least one evaporation channel (122).

9. The heat exchanger fin (100) of one of claims 1 to 8, wherein the filling rate of the channel system with the working fluid is between 40% and 80%.

10. Heat exchanger (500) comprising a base plate (190) and at least one heat exchanger fin (100) of one of claims 1 to 9, whereby the base plate (190) comprises a mounting surface (191) and a contact surface (199), opposite the mounting surface (191), whereby the at least one heat exchanger fin (100) comprises a fin base (119), a fin tip (111) and the channel system that is provided between the fin base (119) and the fin tip (111), and whereby the fin base (119) of the at least one heat exchanger fin (100) is attached to the mounting surface (191) of the base plate (190) for heat transfer between the base plate (190) and the at least one heat exchanger fin (100).

11. Heat exchanger (500) of claim 10, wherein the base plate (190) and the at least one heat exchanger fin (100) are substantially oriented vertical, namely in a range ± 15°, preferably in a range ± 7.5° to vertical, when the heat exchanger (500) is used, wherein the contact surface (199) is in contact with a first heat source (182) and a second heat source (188), and wherein the power requirement and maximum operating temperature allowance of the first heat source (182) is less than that of the second heat source (188) and when in operation, the first heat source (182) is closer to ground (G) than the second heat source (188).

12. A method of manufacturing a heat exchanger fin (100) according to one of claims 1 to 9, comprising the following steps:
- Providing at least one first metal sheet (183) and at least one second metal sheet (187),
- Forming the inner surface of the at least one first metal sheet (183) and/or the inner surface of the at least one second metal sheet (187) to shape channel forming areas of the channel system,
- Vacuum tight bonding, especially welding, the inner surface of the at least one first metal sheet (183) and the inner surface of the at least one second metal sheet (187) in the areas other than the channel forming areas,
- Inserting a working fluid into the channel system and vacuuming out air, and
- Closing the channel system.

13. A method of manufacturing a heat exchanger fin (100) according to one of claims 1 to 9, comprising the following steps:
- Providing at least one first metal sheet (183) and at least one second metal sheet (187),
- Printing a pattern of the channel system on the at least one first metal sheet (183),
- Integrally bonding, especially roll-bonding, the inner surface of the at least one first metal sheet (183) and inner surface of the at least one second metal sheet (187) in areas other than the channels printed areas,
- Inflating the channel system via a gas,
- Inserting a working fluid into the channel system and vacuuming out air, and
- Closing the channel system.

14. The method of claim 12 or 13, wherein the channel system at least initially comprises an open working channel (916) in a working section (918) and the method further comprises the following steps:
- Inserting and securing a working pipe (917) to the working channel (916),
- After inserting the working fluid closing an sealing the working pipe (917) and/or the working channel (916) by flattening and then bonding thereof, and
- At least partially cutting off the working section (918) comprising the working channel (916) and the working pipe (917).

15. The method of one of claims 12 to 14, comprising the following step:
- At least partially forming axial and/or circumferential wick structures on inner surfaces of the channel system forming areas of the at least one first metal sheet (183) and/or the at least one second metal sheet (187), especially in an at least one condensation channel forming area and/or an at least one connecting channel forming area and/or an at least one evaporation channel forming area and/or an braided channels forming area.

## Patentansprüche

1. Eine Wärmetauscherrippe (100) mit einem darin befindlichen Arbeitsfluid, die ein Kanalsystem mit angeschlossenen Bereichen (120, 130, 160, 150) aufweist und so ausgebildet ist, dass eine vollständig thermisch angetriebene Durchströmung des Arbeitsfluids durch die angeschlossenen Bereiche (120, 130, 160, 150) in einem geschlossenen Kreislauf erzeugbar ist, wobei die Wärmetauscherrippe (100) unter Vakuum steht, die angeschlossenen Bereiche mindestens einen ersten Verdampferbereich (120), einen zweiten Verdampferbereich (130), einen ersten Kondensatorbereich (160) und einen zweiten Kondensatorbereich (150) aufweisen,
**dadurch gekennzeichnet, dass** der erste Verdampferbereich (120) anders als der zweite Verdampferbereich (130) und der erste Kondensatorbereich (160) unterschiedlich zu dem zweiten Kondensatorbereich (150) ausgebildet ist, dass der zweite Verdampferbereich (130) und der zweite Kondensatorbereich (150) jeweils eine Vielzahl von Hindernissen (114) aufweisen, die dort ummantelte Kanäle (116) ausbilden, und dass der zweite Verdampferbereich (130) und der zweite Kondensatorbereich (150) zumindest teilweise durch ein Trennungshindernis (113) voneinander getrennt sind, das eine Strömungsseite (145) aufweist, die zumindest einen Teil der Fluidstromverbindung zwischen dem zweiten Verdampferbereich (130) und dem zweiten Kondensatorbereich (150) ausbildet.

2. Die Wärmetauscherrippe (100) nach Anspruch 1, wobei das Volumen des zweiten Kondensatorbereichs (150) zumindest gleich groß oder größer als das Volumen des zweiten Verdampferbereichs (130) ist.

3. Die Wärmetauscherrippe (100) nach Anspruch 1 oder 2, wobei der erste Kondensatorbereich (160) mindestens einen Kondensationskanal (162) aufweist, der mindestens einen Teil einer Fluidstromverbindung zwischen dem zweiten Kondensatorbereich (150) und dem ersten Verdampferbereich (120) ausbildet, und der erste Verdampferbereich (120) mindestens einen Verdampfungskanal (122) aufweist, der mindestens einen Teil einer Fluidstromverbindung zwischen dem ersten Kondensatorbereich (160) und dem zweiten Verdampferbereich (130) ausbildet.

4. Die Wärmetauscherrippe (100) nach einem der Ansprüche 1 bis 3, wobei das Trennungshindernis (113) eine dem zweiten Verdampferbereich (130) zugewandte Verdampfungsseite (144) und eine dem zweiten Kondensatorbereich (150) zugewandte Kondensationsseite (146) aufweist, wobei die Strömungsseite (145) freie Enden der Verdampfungsseite (144) und der Kondensationsseite (146) verbindet und wobei der Strömungsquerschnitt der Fluidstromverbindung zwischen dem zweiten Verdampferbereich (130) und dem zweiten Kondensatorbereich (150) zumindest teilweise in Richtung des zweiten Kondensatorbereichs (150) abnimmt.

5. Die Wärmetauscherrippe (100) nach einem der Ansprüche 1 bis 4, wobei das Trennungshindernis (113) eine Mittelachse der Wärmetauscherrippe (100) definiert, wobei die Mittelachse inneren Umfänge des ersten Verdampferbereichs (120), des zweiten Verdampferbereichs (130), des ersten Kondensatorbereichs (160) bzw. des zweiten Kondensatorbereichs (150) definiert.

6. Die Wärmetauscherrippe (100) nach Anspruch 5, wobei der mindestens eine Kondensationskanal (162) mit dem mindestens einen Verdampfungskanal (122) durch mindestens einen Verbindungskanal (172) verbunden ist, wobei der mindestens eine Verbindungskanal (172) im Wesentlichen schräg zur Mittelachse verläuft.

7. Die Wärmetauscherrippe (100) nach Anspruch 5 oder 6, wobei die Mittelachse im Betrieb der Wärmetauscherrippe (100) im Wesentlichen vertikal, und zwar in einem Bereich von ± 15°, bevorzugt in einem Bereich von ± 7,5° zur Vertikalen, ausgerichtet ist.

8. Die Wärmetauscherrippe (100) nach Anspruch 7, wobei der mindestens eine Verbindungskanal (172) von dem mindestens einen Kondensationskanal (162) zu dem mindestens einen Verdampfungskanal (122) im Wesentlichen aufwärts verläuft.

9. Die Wärmetauscherrippe (100) nach einem der Ansprüche 1 bis 8, wobei der Füllgrad des Kanalsystems mit dem Arbeitsfluid zwischen 40% und 80% beträgt.

10. Ein Wärmetauscher (500) umfassend eine Grundplatte (190) und mindestens eine Wärmetauscherrippe (100) nach einem der Ansprüche 1 bis 9, wobei die Grundplatte (190) eine Montagefläche (191) und eine der Montagefläche (191) gegenüberliegende Kontaktfläche (199) aufweist, wobei die mindestens eine Wärmetauscherrippe (100) eine Rippenbasis (119), eine Rippenspitze (111) und das zwischen der Rippenbasis (119) und der Rippenspitze (111) vorgesehene Kanalsystem umfasst, und wobei die Rippenbasis (119) der mindestens einen Wärmetauscherrippe (100) an der Montagefläche (191) der Grundplatte (190) angebracht ist, um Wärme zwischen der Grundplatte (190) und der mindestens einen Wärmetauscherrippe (100) zu übertragen.

11. Der Wärmetauscher (500) nach Anspruch 10, wobei die Grundplatte (190) und die mindestens eine Wärmetauscherrippe (100) im Wesentlichen vertikal, und zwar in einem Bereich ± 15°, bevorzugt in einem Bereich ± 7,5° zur Vertikalen, ausgerichtet sind, wenn der Wärmetauscher (500) in Betrieb ist, und wobei die Kontaktfläche (199) mit einer ersten Wärmequelle (182) und einer zweiten Wärmequelle (188) in Kontakt steht, und wobei der Energiebedarf und die maximale Betriebstemperaturabweichung der ersten Wärmequelle (182) geringer ist als die der zweiten Wärmequelle (188) und die erste Wärmequelle (182) im Betrieb näher am Boden (G) angeordnet ist als die zweite Wärmequelle (188).

12. Ein Verfahren zur Herstellung einer Wärmetauscherrippe (100) nach einem der Ansprüche 1 bis 9, umfassend die folgenden Schritte:
- Bereitstellen mindestens eines ersten Metallblechs (183) und mindestens eines zweiten Metallblechs (187),
- Ausbilden der Innenfläche des mindestens einen ersten Metallblechs (183) und/oder der Innenfläche des mindestens einen zweiten Metallblechs (187) zum Ausbilden von kanalbildenden Bereichen des Kanalsystems,
- vakuumdichtes Verbinden, insbesondere Verschweißen, der Innenfläche des mindestens einen ersten Metallblechs (183) und der Innenfläche des mindestens einen zweiten Metallblechs (187) in anderen Bereichen als den kanalbildenden Bereichen,
- Einbringen eines Arbeitsfluids in das Kanalsystem und Absaugen von Luft, und
- Verschließen des Kanalsystems.

13. Ein Verfahren zur Herstellung einer Wärmetauscherrippe (100) nach einem der Ansprüche 1 bis 9, umfassend die folgenden Schritte:
- Bereitstellen mindestens eines ersten Metallblechs (183) und mindestens eines zweiten Metallblechs (187),
- Aufdrucken eines Kanalsystemmusters auf das mindestens eine erste Metallblech (183),
- Integrales Verbinden, insbesondere Walzverbindenkleben, der Innenfläche des mindestens einen ersten Metallblechs (183) und der Innenfläche des mindestens einen zweiten Metallblechs (187) in anderen Bereichen als den aufgedruckten Kanalbereichen,
- Aufblasen des Kanalsystems durch ein Gas,
- Einbringen eines Arbeitsfluids in das Kanalsystem und Absaugen von Luft, und
- Verschließen des Kanalsystems.

14. Das Verfahren nach Anspruch 12 oder 13, wobei das Kanalsystem zumindest anfänglich in einem Arbeitsabschnitt (918) einen offenen Arbeitskanal (916) aufweist und wobei das Verfahren ferner die folgenden Schritte aufweist:
- Einführen und Befestigen eines Arbeitsrohres (917) in den Arbeitskanal (916),
- Verschließen und Abdichten des Arbeitsrohrs (917) und/oder des Arbeitskanals (916) nach dem Einbringen des Arbeitsfluids durch Abflachen und anschließendes Verbinden, und
- zumindest teilweises Abschneiden des den Arbeitskanal (916) und das Arbeitsrohr (917) umfassenden Arbeitsabschnitts (918).

15. Das Verfahren nach einem der Ansprüche 12 bis 14, umfassend den folgenden Schritt:
- zumindest teilweises Ausbilden von axialen und/oder umlaufenden Mantelstrukturen auf Innenflächen der das Kanalsystem ausbildenden Bereiche des mindestens einen ersten Metallblechs (183) und/oder des mindestens einen zweiten Metallblechs (187), insbesondere in einem mindestens einen Kondensationskanal ausbildenden Bereich und/oder in einem mindestens einen Verbindungskanal ausbildenden Bereich und/oder in einem mindestens einen Verdampfungskanal ausbildenden Bereich und/oder in einem einen ummantelten Kanal ausbildenden Bereich.

## Revendications

1. Ailette d'échangeur de chaleur (100) comportant un fluide de travail, comprenant un système de canal comportant des régions subséquentes (120, 130, 160, 150) et configuré de telle sorte qu'un flux subséquent entièrement entraîné thermiquement du fluide de travail à travers les régions subséquentes (120, 130, 160, 150) dans une configuration en boucle fermée peut être produit,
dans laquelle l'ailette d'échangeur de chaleur (100) est sous vide, et les régions subséquentes comprennent au moins une première région d'évaporateur (120), une deuxième région d'évaporateur (130), une première région de condenseur (160) et une deuxième région de condenseur (150),
**caractérisée en ce que** la première région d'évaporateur (120) est configurée différemment de la deuxième région d'évaporateur (130) et la première région de condenseur (160) est configurée différemment de la deuxième région de condenseur (150), **en ce que** la deuxième région d'évaporation (130) et la deuxième région de condenseur (150) comprennent chacune une pluralité d'obturateurs (114) formant autour d'eux des canaux tressés (116), et **en ce que** la deuxième région d'évaporateur (130) et la deuxième région de condenseur (150) sont au moins partiellement séparées l'une de l'autre par un obturateur de division (113) ayant un côté d'écoulement (145) formant au moins une partie de la connexion d'écoulement de fluide entre la deuxième région d'évaporateur (130) et la deuxième région de condenseur (150).

2. Ailette d'échangeur de chaleur (100) selon la revendication 1, dans laquelle le volume de la deuxième région de condenseur (150) est supérieur ou égal au volume de la deuxième région d'évaporateur (130).

3. Ailette d'échangeur de chaleur (100) selon la revendication 1 ou 2, dans laquelle la première région de condenseur (160) comprend au moins un canal de condensation (162) formant au moins une partie d'une connexion d'écoulement de fluide entre la deuxième région de condenseur (150) et la première région d'évaporateur (120), et la première région d'évaporateur (120) comprend au moins un canal d'évaporation (122) formant au moins une partie d'une connexion d'écoulement de fluide entre la première région de condenseur (160) et la deuxième région d'évaporateur (130).

4. Ailette d'échangeur de chaleur (100) selon l'une des revendications 1 à 3, dans laquelle l'obturateur de division (113) comporte un côté d'évaporation (144) qui fait face à la deuxième région d'évaporateur (130) et un côté de condensation (146) qui fait face à la deuxième région de condenseur (150), moyennant quoi le côté d'écoulement (145) connecte les extrémités libres du côté d'évaporation (144) et du côté de condensation (146), et moyennant quoi la section transversale d'écoulement de la connexion d'écoulement de fluide entre la deuxième région d'évaporateur (130) et la deuxième région de condenseur (150) diminue au moins partiellement vers la deuxième région de condenseur (150).

5. Ailette d'échangeur de chaleur (100) selon l'une des revendications 1 à 4, dans laquelle l'obturateur de division (113) définit un axe médian de l'ailette d'échangeur de chaleur (100), moyennant quoi l'axe médian définit respectivement des périmètres internes de la première région d'évaporateur (120), de la deuxième région d'évaporateur (130), de la première région de condenseur (160) et de la deuxième région de condenseur (150).

6. Ailette d'échangeur de chaleur (100) selon la revendication 5, dans laquelle ledit au moins un canal de condensation (162) est connecté audit au moins un canal d'évaporation (122) par au moins un canal de connexion (172), moyennant quoi ledit au moins un canal de connexion (172) est substantiellement oblique par rapport à l'axe médian.

7. Ailette d'échangeur de chaleur (100) selon la revendication 5 ou 6, dans laquelle l'axe médian est orienté de manière substantiellement verticale, à savoir dans une plage de ± 15°, et préférablement dans une plage de ± 7,5°, par rapport à la verticale, quand l'ailette d'échangeur de chaleur (100) est en service.

8. Ailette d'échangeur de chaleur (100) selon 7, dans laquelle ledit au moins un canal de connexion (172) est substantiellement dirigé vers le haut depuis ledit au moins un canal de condensation (162) jusqu'audit au moins un canal d'évaporation (122).

9. Ailette d'échangeur de chaleur (100) selon l'une des revendications 1 à 8, dans laquelle le taux de remplissage du système de canal avec le fluide de travail est compris entre 40 % et 80 %.

10. Échangeur de chaleur (500) comprenant une plaque de base (190) et au moins une ailette d'échangeur de chaleur (100) selon l'une des revendications 1 à 9, moyennant quoi la plaque de base (190) comprend une surface de montage (191) et une surface de contact (199) opposée à la surface de montage (191), moyennant quoi ladite au moins une ailette d'échangeur de chaleur (100) comprend une base d'ailette (119), une pointe d'ailette (111), et le système de canal qui est pourvu entre la base d'ailette (119) et la pointe d'ailette (111), et moyennant quoi la base d'ailette (119) de ladite au moins une ailette d'échangeur de chaleur (100) est attachée à la surface de montage (191) de la plaque de base (190) pour un transfert de chaleur entre la plaque de base (190) et ladite au moins une ailette d'échangeur de chaleur (100).

11. Échangeur de chaleur (500) selon la revendication 10, dans lequel la plaque de base (190) et ladite au moins une ailette d'échangeur de chaleur (100) sont orientées de manière substantiellement verticale, à savoir dans une plage de ± 15°, et préférablement dans une plage de ± 7,5°, par rapport à la verticale, quand l'échangeur de chaleur (500) est utilisé, dans lequel la surface de contact (199) est en contact avec une première source de chaleur (182) et une deuxième source de chaleur (188), et dans lequel l'exigence de puissance et la plage de température de fonctionnement maximale de la première source de chaleur (182) sont inférieures à celles de la deuxième source de chaleur (188), et quand en service la première source de chaleur (182) est plus proche du sol (G) que la deuxième source de chaleur (188).

12. Procédé de fabrication d'une ailette d'échangeur de chaleur (100) selon l'une des revendications 1 à 9, comprenant les étapes suivantes :
- fourniture d'au moins une première tôle (183) et d'au moins une deuxième tôle (187),
- formation de la surface interne de ladite au moins une première tôle (183) et/ou de la surface interne de ladite au moins une deuxième tôle (187) pour former des zones de formation de canal du système de canal,
- assemblage étanche à l'air, en particulier par soudage, de la surface interne de ladite au moins une première tôle (183) et de la surface interne de ladite au moins une deuxième tôle (187) dans les zones autres que les zones de formation de canal,
- insertion d'un fluide de travail dans le système de canal et aspiration de l'air pour former le vide, et
- fermeture du système de canal.

13. Procédé de fabrication d'une ailette d'échangeur de chaleur (100) selon l'une des revendications 1 à 9, comprenant les étapes suivantes :
- fourniture d'au moins une première tôle (183) et d'au moins une deuxième tôle (187),
- impression d'un motif du système de canal sur ladite au moins une première tôle (183),
- assemblage intégral, en particulier par laminage, de la surface interne de ladite au moins une première tôle (183) et de la surface interne de ladite au moins une deuxième tôle (187) dans des zones autres que les zones imprimées des canaux,
- gonflage du système de canal via un gaz,
- insertion d'un fluide de travail dans le système de canal et aspiration de l'air pour former le vide, et
- fermeture du système de canal.

14. Procédé selon la revendication 12 ou 13, dans lequel le système de canal comprend, au moins initialement, un canal fonctionnel ouvert (916) dans une section fonctionnelle (918), et le procédé comprend en outre les étapes suivantes :
- insertion et fixation d'un tuyau fonctionnel (917) dans le canal fonctionnel (916),
- après l'insertion du fluide de travail, fermeture et scellement du tuyau fonctionnel (917) et/ou du canal fonctionnel (916) en l'aplatissant et ensuite en l'assemblant, et
- découpe, au moins partielle, de la section fonctionnelle (918) comprenant le canal fonctionnel (916) et le tuyau fonctionnel (917).

15. Procédé selon l'une des revendications 12 à 14, comprenant l'étape suivante :
- formation au moins partielle de structures de mèche axiales et/ou circonférentielles sur des surfaces internes des zones de formation de système de canal de ladite au moins une première tôle (183) et/ou de ladite au moins une deuxième tôle (187), en particulier dans au moins une zone de formation de canal de condensation et/ou au moins une zone de formation de canal de connexion et/ou au moins une zone de formation de canal d'évaporation et/ou une zone de formation de canaux tressés.
